# EUROPÄISCHE PATENTSCHRIFT

(11) **EP 4 328 610 B1**
(45) Veröffentlichungstag und Bekanntmachung des Hinweises auf die Patenterteilung: **10.06.2026**
(21) Anmeldenummer: 22192179.4
(22) Anmeldetag: 25.08.2022
(51) Int. Cl.: G01R 33/385, G01R 33/421

(54) **GRADIENTENSPULENEINHEIT FÜR INTERVENTIONELLE MR-BILDGEBUNG**
GRADIENT COIL UNIT FOR INTERVENTIONAL MR IMAGING
UNITÉ DE BOBINES DE GRADIENT POUR IMAGERIE PAR RÉSONANCE MAGNÉTIQUE INTERVENTIONNELLE

(43) Veröffentlichungstag der Anmeldung: 28.02.2024
(73) Patentinhaber: Siemens Healthineers AG, 91301 Forchheim (DE)
(72) Erfinder: Körber, Simon, 91352 Hallerndorf (DE); vom Endt, Axel, 91052 Erlangen (DE)
(74) Vertreter: Siemens Healthineers Patent Attorneys

(56) Entgegenhaltungen:
- WO-A1-2004/046745
- WO-A1-2020/118352
- FANGANG TANG ET AL: "A cone-shaped gradient coil design for high-resolution MRI head imaging", PHYSICS IN MEDICINE AND BIOLOGY, INSTITUTE OF PHYSICS PUBLISHING, BRISTOL GB, vol. 64, no. 8, 5 April 2019 (2019-04-05), pages 85003, XP020339372, ISSN: 0031-9155, [retrieved on 20190405], DOI: 10.1088/1361-6560/AB084A

## Beschreibung

Die Erfindung betrifft eine Gradientenspuleneinheit für interventionelle MR-Bildgebung und ein Magnetresonanzgerät.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 Tesla, ausgesetzt. Im Rahmen einer Magnetresonanzbildgebung (MR-Bildgebung) werden mit Hilfe einer Gradientenspuleneinheit Gradientenpulse ausgespielt. Zusätzlich werden über eine Hochfrequenzantenneneinheit dann mittels geeigneter Antenneneinrichtungen hochfrequente Hochfrequenz-Pulse (HF-Pulse), insbesondere Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Eine Gradientenspuleneinheit umfasst herkömmlich drei Primärspulen und drei dazu korrespondierende Sekundärspulen. Die drei Primärspulen werden typischerweise von einer Primärspuleneinheit umfasst. Die drei Sekundärspulen werden typischerweise von einer Sekundärspuleneinheit umfasst. Eine Primärspule ist typischerweise zur Erzeugung eines Magnetfeldgradienten in eine Raumrichtung ausgelegt, insbesondere innerhalb eines Patientenaufnahmebereiches. Ein Magnetfeldgradient ist typischerweise ein Magnetfeld erster Ordnung und/oder linearer Ordnung, insbesondere ein Magnetfeld, dessen Amplitude entlang einer Raumrichtung linear ansteigt. Außerhalb des Patientenaufnahmebereiches wird die Wirkung einer Primärspule durch eine der Primärspule zugeordnete Sekundärspule weitgehend unterdrückt. Die Sekundärspule umgibt typischerweise die entsprechende Primärspule und ist mit dieser elektrisch in Serie geschaltet. Der Magnetfeldgradient und das Hauptmagnetfeld weisen typischerweise nur innerhalb eines Teilbereiches des Patientenaufnahmebereiches, auch Untersuchungsbereich genannt, eine für die MR-Bildgebung erforderliche Homogenität auf. Der Untersuchungsbereich ist dabei typischerweise zentral, also mittig innerhalb des zylindrischen Patientenaufnahmebereiches angeordnet und dadurch aufgrund der Länge sogenannter geschlossener Magnetresonanzgeräte von einem Ende des Magnetresonanzgerätes, beispielsweise durch medizinisches Fachpersonal, schwer erreichbar. Die Größe des Untersuchungsbereiches kann beispielsweise 40cm x 40cm x 40cm betragen.

Bei minimalinvasiven medizinischen Prozeduren werden medizinische Instrumente, beispielsweise Katheter und/oder Eingriffsnadeln, in einen Patienten eingeführt, wobei üblicherweise eine Bildüberwachung der Prozedur erfolgt. Die Bildüberwachung ermöglicht die Aufnahme von Bildern, in denen das medizinische Instrument in Bezug zu seiner anatomischen Umgebung sichtbar gemacht wird. Während klassischerweise Röntgenbildgebung zur Bildüberwachung minimalinvasiver medizinischer Eingriffe verwendet wurde, insbesondere Fluoroskopie, wurde inzwischen auch vorgeschlagen, Magnetresonanzgeräte, mithin die Magnetresonanzbildgebung (MR-Bildgebung), zur Bildüberwachung einzusetzen. Dies wird typischerweise als interventionelle MR-Bildgebung bezeichnet.

Eine spezielle Art von medizinischen Instrumenten, die häufig für minimalinvasive medizinische Eingriffe eingesetzt werden, sind Eingriffsnadeln, die beispielsweise für die Biopsie, die Ablation oder die Brachytherapie verwendet werden. Auch bezüglich von Eingriffsnadeln wurde bereits vorgeschlagen, diese unter Magnetresonanz-Echtzeitkontrolle zu propagieren.

Herkömmlich werden derartige minimalinvasive medizinische Eingriffe schrittweise durchgeführt, wobei die Eingriffsnadel außerhalb des Untersuchungsbereiches des Magnetresonanzgerätes am Untersuchungsobjekt gesetzt wird, anschließend das Untersuchungsobjekt mittels einer Patientenlagerungsvorrichtung derart innerhalb des Patientenaufnahmebereiches positioniert wird, dass die Eingriffsnadel im Untersuchungsbereich positioniert ist und die Position und/oder Lage der Eingriffsnadel mittels MR-Bildgebung kontrollierbar ist. Die Ausführung des eigentlich invasiven Prozesses durch den Arzt erfolgt wieder in der Ausgangsposition außerhalb des Untersuchungsbereiches. Weitere Kontrollen mit wiederholter Positionierung des Untersuchungsobjektes innerhalb des Untersuchungsbereiches sind typischerweise erforderlich.

FANGANG TANG ET AL: "A cone-shaped gradient coil design for high-resolution MRI head imaging", PHYSICS IN MEDICINE AND BIOLOGY, INSTITUTE OF PHYSICS PUBLISHING, BRISTOL GB, Bd. 64, Nr. 8, 5. April 2019 (2019-04-05), offenbart eine konische geformte Gradientenspuleneinheit für die MR-Bildgebung des Kopfes. WO 2020/118352 A1 beschreibt eine kegelstumpfförmige Gradientenspuleneinheit mit Shimtaschen. WO 2004/046745 A1 beschreibt eine selbstschirmende Gradientenspuleneinheit für die MR-Bildgebung.

Der Erfindung liegt die Aufgabe zugrunde, eine Gradientenspuleneinheit, welche besonders gut für die interventionelle MR-Bildgebung geeignet ist, anzugeben. Die Aufgabe wird durch die Merkmale der unabhängigen Ansprüche gelöst. Vorteilhafte Ausgestaltungen sind in den Unteransprüchen beschrieben.

Das erfindungsgemäße Gradientenspuleneinheit umgibt einen zylindrischen Patientenaufnahmebereich und umfasst eine hohlzylindrische Primärspule und eine hohlzylindrische Sekundärspule, welche die Primärspule und den Patientenaufnahmebereich koaxial und/oder konzentrisch umgibt. Die Gradientenspuleneinheit weist ein erstes Längsende in eine Längsrichtung auf, welches erste Längsende zur Aufnahme eines Untersuchungsobjektes ausgebildet ist. Die Gradientenspuleneinheit weist ein dem ersten Längsende in Längsrichtung gegenüberliegendes zweites Längsende auf. Die Primärspule weist eine erste Länge in Längsrichtung auf, welche erste Länge durch eine dem ersten Längsende zugewandte erste Längsposition und eine dem zweiten Längsende zugewandte zweite Längsposition begrenzt ist. Die Sekundärspule weist eine zweite Länge in Längsrichtung auf, welche zweite Länge durch eine dem ersten Längsende zugewandte dritte Längsposition und eine dem zweiten Längsende zugewandte vierte Längsposition begrenzt wird. Die erste Längsposition weist einen größeren Abstand zum ersten Längsende auf als die dritte Längsposition. Die erste Länge ist vorzugsweise kürzer als die zweite Länge.

Die Gradientenspuleneinheit ist demnach hohlzylindrisch ausgestaltet und umgibt zumindest teilweise den Patientenaufnahmebereich. Die Gradientenspuleneinheit ist vorzugsweise als Ganzkörperspule ausgebildet, sodass der Patientenaufnahmebereich beispielsweise ein Abdomen und/oder einen Schulterbereich des Untersuchungsobjektes in Umfangrichtung vollständig aufnehmen und/oder umschließen kann. Die Zylinderachse der Gradientenspuleneinheit kann als Längsachse und/oder z-Achse bezeichnet werden und ist typischerweise horizontal ausgerichtet und/oder ist parallel zu Längsrichtung. Die Primärspule ist vorzugsweise zur Erzeugung eines Magnetfeldgradienten in eine Raumrichtung ausgebildet. Die Sekundärspule ist vorzugsweise zur Abschirmung des von der Primärspule erzeugten Magnetfeldgradienten im vom Patientenaufnahmebereich abgewandten Bereich der Gradientenspuleneinheit ausgebildet. Das erste Längsende der Gradientenspuleneinheit ist typischerweise an der Seite der Untersuchungsbereiches angeordnet, an welcher Seite ein Untersuchungsobjekt mittels Patientenlagerungsvorrichtung in den Untersuchungsbereich einbringbar ist. Das zweite Längsende der Gradientenspuleneinheit entspricht typischerweise der Seite der Gradientenspuleneinheit, an welcher die Anschlusskabel der Gradientenspuleneinheit vorgesehen sind. Das zweite Längsende ist dem ersten Längsende in Längsrichtung typischerweise abgewandt. Die erste Länge und die zweite Länge beziehen sich typischerweise auf parallel verlaufende Geraden, insbesondere in Längsrichtung, zwischen erstem Längsende und zweitem Längsende. Die zweite Längsposition kann der vierten Längsposition entsprechen. Die zweite Längsposition und/oder die vierte Längsposition ist dem ersten Längsende typischerweise abgewandt. Die Primärspule und die Sekundärspule können demnach am zweiten Längsende bündig ausgestaltet sein. Eine Längsposition ist typischerweise eine Koordinate der Längsachse, insbesondere eine Koordinate der z-Achse.

Die erfindungsgemäße Gradientenspuleneinheit ist demnach derart ausgebildet, dass die auf der dem Patientenaufnahmebereich zugewandten Seite der Gradientenspuleneinheit angeordnete Primärspule kürzer ist als die Sekundärspule. Die kürzere erste Länge der Primärspule bewirkt insbesondere, dass am ersten Längsende ein größerer Innendurchmesser des Patientenaufnahmebereiches realisierbar ist. Dies erleichtert dem medizinischen Fachpersonal Zugriff auf den Untersuchungsbereich von außerhalb der Gradientenspuleneinheit und ermöglicht so besonders gut interventionelle MR-Bildgebung.

Eine Ausführungsform der Gradientenspuleneinheit umfasst eine Verschalung, welche die Gradientenspuleneinheit zumindest teilweise umschließt und am ersten Längsende trichterförmig ausgestaltet ist. Eine Verschalung kann als Gehäuse und/oder Hülle und/oder Einhausung für die Primärspule und die Sekundärspule ausgebildet sein. Die Gradientenspuleneinheit weist demnach am ersten Längsende vorzugsweise eine trichterförmige Öffnung auf, was dem medizinischen Fachpersonal besonders guten Zugang zum Untersuchungsbereich auch von außerhalb der Gradientenspuleneinheit ermöglicht.

Insbesondere kann das medizinische Fachpersonal seinen Oberkörper und/oder Schulterbereich der Öffnung zuwenden, was interventionelle MR-Bildgebung innerhalb des Patientenaufnahmebereiches besonders gut ermöglicht.

Eine Ausführungsform der Gradientenspuleneinheit sieht vor, dass sich die erste Längsposition und die dritte Längsposition um zumindest 3 cm, vorzugsweise um zumindest 4 cm, besonders bevorzugt um zumindest 6 cm unterscheiden. Die erste Längsposition weist demnach einen um zumindest 3 cm geringeren Abstand zu einem Isozentrum der Gradientenspuleneinheit auf als die dritte Längsposition. Der Abstand der ersten Längsposition zu dem Isozentrum der Gradientenspuleneinheit ist typischerweise kürzer als der Abstand der zweiten Längsposition zu dem Isozentrum der Gradientenspuleneinheit.

Der Abstand der ersten Längsposition zu dem Isozentrum der Gradientenspuleneinheit beträgt typischerweise zwischen 500 mm und 700 mm, bevorzugt zwischen 580 mm und 620 mm, besonders bevorzugt zwischen 590 mm und 610 mm. Der Abstand der zweiten Längsposition zu dem Isozentrum der Gradientenspuleneinheit beträgt typischerweise zwischen 620 mm und 750 mm, bevorzugt zwischen 650 mm und 710 mm, besonders bevorzugt zwischen 670 mm und 690 mm. Der Abstand der dritten Längsposition zu dem Isozentrum der Gradientenspuleneinheit unterscheidet sich typischerweise um weniger als 2 cm, bevorzugt um weniger als 1 cm, besonders bevorzugt um weniger als 0,5 cm vom Abstand der zweiten Längsposition zu dem Isozentrum der Gradientenspuleneinheit. Die erste Länge beträgt typischerweise zwischen 1100 mm und 1400 mm, bevorzugt zwischen 1200 mm und 1300 mm, besonders bevorzugt zwischen 1235 mm und 1265 mm. Die zweite Länge beträgt typischerweise zwischen 1200 mm und 1400 mm, bevorzugt zwischen 1250 mm und 1350 mm, besonders bevorzugt zwischen 1285 mm und 1315 mm. Der Abstand der zweiten Längsposition zu dem Isozentrum der Gradientenspuleneinheit beträgt typischerweise zwischen 600 mm und 700 mm, bevorzugt zwischen 620 mm und 680 mm, besonders bevorzugt zwischen 640 mm und 660 mm.

Diese Ausführungsform ermöglicht eine trichterförmige Öffnung am ersten Längsende und eine bessere Erreichbarkeit des Untersuchungsbereiches bei gleichzeitiger kompakter Bauweise.

Eine Ausführungsform der Gradientenspuleneinheit sieht vor, dass sich die zweite Längsposition und die vierte Längsposition um höchstens 4 cm, bevorzugt um höchstens 2 cm, besonders bevorzugt um höchstens 1 cm unterscheiden. Die Sekundärspule und die Primärspule können am zweiten Längsende auch bündig abschließen. Dies ermöglicht eine besonders kompakte Bauweise der Gradientenspuleneinheit.

Eine Ausführungsform der Gradientenspuleneinheit sieht vor, dass die Gradientenspuleneinheit einen Innendurchmesser von zumindest 840 mm und eine räumliche Ausdehnung in Längsrichtung von höchstens 1350 mm aufweist. Der Innendurchmesser bezieht sich typischerweise auf den Durchmesser des von der Primärspule und/oder der Verschalung umgebenen Zylinders. Der Innendurchmesser der Gradientenspuleneinheit beträgt gemäß dieser Ausführungsform zumindest 840 mm, bevorzugt zumindest 855 mm, besonders bevorzugt zumindest 865 mm. Die räumliche Ausdehnung der Gradientenspuleneinheit in Längsrichtung kann der zweiten Länge entsprechen und/oder größer als diese sein. Die Länge der Gradientenspuleneinheit in Längsrichtung ist gemäß dieser Ausführungsform geringer als 1350 mm, bevorzugt geringer als 1340 mm, besonders bevorzugt geringer als 1328 mm.

Diese Ausführungsform ermöglicht einen Untersuchungsbereich mit einem Durchmesser von 800 mm und einen Abstand des Trichtereingangs vom Isozentrum und/oder vom Untersuchungsbereich von weniger als 600 mm. Diese Geometrie ermöglicht eine besonders einfache und dennoch kontrollierte Verwendung von Eingriffsnadeln innerhalb des Patientenaufnahmebereiches.

Erfindungsgemäß ist vorgesehen, dass die Gradientenspuleneinheit in vier Quadranten unterteilbar und/oder gliederbar ist, die Primärspule vier spiralförmige primäre Leiterstrukturen umfasst, welche jeweils innerhalb eines Quadranten umgebend jeweils einen primären Fixpunkt angeordnet sind, und die Sekundärspule vier spiralförmige sekundäre Leiterstrukturen umfasst, welche jeweils innerhalb eines Quadranten umgebend jeweils einen sekundären Fixpunkt angeordnet sind. Zudem sieht diese Ausführungsform der Gradientenspuleneinheit einen ersten Abschnitt der Primärspule vor, welcher in Längsrichtung durch die erste Längsposition und durch eine weitere primäre Längsposition im Abstand zwischen 10% und 25% der ersten Länge zur ersten Längsposition begrenzt ist, und frei von einem Verbindungsleiter ist, welcher Verbindungsleiter zwei primäre Leiterstrukturen miteinander und/oder eine primäre Leiterstruktur mit einer sekundären Leiterstruktur verbindet.

Die Gradientenspuleneinheit ist typischerweise in vier Quadranten unterteilbar und/oder die Gradientenspuleneinheit umfasst vier Quadranten, wobei diese vier Quadranten typischerweise lediglich vier disjunkte geometrische Bereiche der Gradientenspuleneinheit definieren. Die vier Quadranten bezeichnen typischerweise Bereiche der Gradientenspuleneinheit, wobei ein Übergang zwischen zwei Quadranten jeweils frei von einer physischen und/oder sichtbaren Trennung ist. Die primäre Leiterstruktur ist vorzugsweise Teil der Primärspule, welche die primäre Leiterstruktur typischerweise viermal, angeordnet jeweils in einem Quadranten der vier Quadranten, umfasst, und die Primärspule zur Erzeugung eines Magnetfeldgradienten in eine Raumrichtung ausgebildet ist. Eine Leiterstruktur, wie im Folgenden beschrieben, kann als primäre Leiterstruktur oder sekundäre Leiterstruktur ausgebildet sein. Die Leiterstruktur umfasst typischerweise eine geometrische Anordnung eines elektrischen Leiters. Die Leiterstruktur ist typischerweise auf einem Zylinder angeordnet und sattelförmig ausgestaltet. Die Leiterstruktur wird räumlich typischerweise von einem Quadranten der Gradientenspuleneinheit begrenzt. Die Leiterstruktur ist vorzugsweise zumindest teilweise spiralförmig, aufweisend Windungen mit unterschiedlichem Radius relativ zu einem Fixpunkt, geformt. Eine primäre Leiterstruktur umgibt typischerweise einen primären Fixpunkt zumindest teilweise spiralförmig und/oder eine sekundäre Leiterstruktur umgibt typischerweise einen sekundären Fixpunkt zumindest teilweise spiralförmig.

Die vier primären Leiterstrukturen und die vier sekundären Leiterstrukturen sind typischerweise in Serie elektrisch miteinander verbunden. Elektrische Leiter verbindend zwei primäre Leiterstrukturen aus verschiedenen Quadranten oder verbindend zwei sekundäre Leiterstrukturen aus verschiedenen Quadranten oder verbindend eine primäre Leiterstruktur und eine sekundäre Leiterstruktur können als Verbindungsleiter bezeichnet werden. Verbindungsleiter können als primäre Verbindungsleiter oder als sekundäre Verbindungsleiter ausgestaltet sein. Primäre Verbindungsleiter verbinden typischerweise zwei primäre Leiterstrukturen aus zwei verschiedenen Quadranten oder eine primäre Leiterstruktur mit einer sekundären Leiterstruktur. Sekundäre Verbindungsleiter verbinden typischerweise zwei sekundäre Leiterstrukturen aus zwei verschiedenen Quadranten. Ein Verbindungsleiter stellt typischerweise eine elektrische Verbindung zwischen zwei Quadranten und/oder zwischen Primärspule und Sekundärspule dar. Ein Verbindungsleiter ist typischerweise überwiegend geradlinig ausgestaltet, insbesondere nicht spiralförmig ausgestaltet.

Der erste Abschnitt der Gradientenspuleneinheit ist erfindungsgemäß frei von einem Verbindungsleiter und umfasst folglich vorzugsweise ausschließlich elektrische Leiter, welche Teil einer primären Leiterstruktur sind und somit aktiv zur Erzeugung eines Magnetfeldgradienten beitragen. Der erste Abschnitt kann demnach räumlich besonders effizient zur Erzeugung des Magnetfeldgradienten verwendet werden, da typischerweise sämtliche Anschlüsse und technisch erforderliche Verbindungen außerhalb des ersten Abschnittes angeordnet sind. Verbindungsleiter sind gemäß dieser Ausführungsform außerhalb des ersten Abschnittes und/oder insbesondere nahe des zweiten Längsendes angeordnet, wodurch diese die Homogenität des Untersuchungsbereiches und den Magnetfeldgradient am ersten Längsende weniger stark beeinflussen. Zudem ist typischerweise im Bereich außerhalb des ersten Abschnittes und/oder insbesondere nahe des zweiten Längsendes die Dichte des von den Leiterstrukturen, insbesondere den primären Leiterstrukturen, umfassten elektrischen Leiters geringer als im ersten Abschnitt, wodurch die Primärspule in diesem Bereich ausreichend Platz zur Aufnahme der Verbindungsleiter aufweist. Die elektrischen Leiter innerhalb des ersten Abschnitts können demnach ohne Berücksichtigung von Verbindungsleiter hinsichtlich idealer Homogenität des Magnetfeldgradienten nahe des ersten Längsendes optimiert sein. Der erste Abschnitt grenzt typischerweise an das erste Längsende, wodurch der Untersuchungsbereich, insbesondere der Bereich hoher Homogenität der Magnetfeldgradienten, besonders nahe am ersten Längsende erzeugbar ist. Dies ermöglicht einen besonders guten Zugang des medizinischen Fachpersonals zum Untersuchungsbereich und dadurch eine besonders einfach auszuführende interventionelle MR-Bildgebung.

Eine Ausführungsform der Gradientenspuleneinheit sieht vor, dass die primären Leiterstrukturen, insbesondere die primären Leiterstrukturen, die innerhalb eines sich mit dem ersten Abschnitt überlappenden Quadranten angeordnet sind, innerhalb des ersten Abschnittes jeweils die höchste Dichte elektrischer Leiter aufweisen. Die entsprechenden primären Leiterstrukturen sind demnach derart ausgestaltet, dass die maximale Dichte des elektrischen Leiters der entsprechenden primären Leiterstruktur innerhalb zumindest eines Teilbereiches des ersten Abschnittes vorliegt. Der Teilbereich umfasst typischerweise zumindest 10%, bevorzugt zumindest 15%, besonders bevorzugt zumindest 20% des ersten Abschnittes. Insbesondere ist eine innerhalb eines dem ersten Längsende angrenzenden Quadranten angeordnete primäre Leiterstruktur derart ausgebildet, dass im ersten Abschnitt die höchste Stromdichte der Primärspule erzeugbar ist. Gemäß dieser Ausführungsform sehen die in Längsrichtung dem ersten Längsende zugewandten primären Leiterstrukturen im ersten Abschnitt einen besonders geringen Abstand zwischen benachbarten Windungen des elektrischen Leiters der primären Leiterstrukturen vor. Dies ermöglicht eine besonders hohe Stromdichte am ersten Längsende gemittelt in Längsrichtung über den ersten Abschnitt an zumindest einer Position in Umfangsrichtung. Die Dichte eines elektrischen Leiters kann durch die Anzahl der elektrischen Leiter pro Querschnittsfläche der Primärspule senkrecht zum elektrischen Leiter und/oder die Summe der Fläche der Leiterquerschnitte pro Querschnittsfläche der Primärspule senkrecht zum elektrischen Leiter bestimmt sein. Je höher die Dichte spiralförmig angeordneter elektrischer Leiter mit gleichgerichteter Stromrichtung, insbesondere je geringer der Abstand zwischen benachbarten Windungen, wie beispielsweise bei einer primären Leiterstruktur innerhalb eines Quadranten, desto höher ist die elektrische Stromdichte in diesem Bereich. Dies ermöglicht innerhalb des ersten Abschnittes eine besonders hohe Stromdichte, was insbesondere dazu führt, dass der Bereich innerhalb des Patientenaufnahmebereiches mit höchster Homogenität der Magnetfeldgradienten, also der Untersuchungsbereich, näher am ersten Längsende ist als am zweiten Längsende. Dadurch ist der Untersuchungsbereich vom ersten Längsende für interventionelle Untersuchungen besonders gut zugänglich. Zudem kann die Gradientenspuleneinheit in Längsrichtung im Vergleich zu herkömmlichen Gradientenspuleneinheiten besonders kurz ausgestaltet sein.

Eine Ausführungsform der Gradientenspuleneinheit umfasst einen primären Verbindungsleiter, welcher zwei primäre Leiterstrukturen miteinander und/oder eine primäre Leiterstruktur mit einer sekundären Leiterstruktur verbindet, und welcher an eine dem zumindest einen primären Fixpunkt nächste Windung der primären Leiterstruktur anschließt. Der primäre Verbindungsleiter verbindet gemäß dieser Ausführungsform ein Auge einer primären Leiterstruktur mit einer weiteren primären Leiterstruktur oder sekundären Leiterstruktur. Dies ermöglicht insbesondere, den ersten Abschnitt frei von einem Verbindungsleiter, insbesondere einem primären Verbindungsleiter, zu gestalten, da der Verbindungsleiter vom primären Fixpunkt zum zweiten Längsende führen kann.

Eine Ausführungsform der Gradientenspuleneinheit sieht vor, dass ein zweiter Abschnitt der Sekundärspule, welcher in Längsrichtung durch die dritte Längsposition und durch eine weitere sekundäre Längsposition im Abstand von höchstens 25% der zweiten Länge zur dritten Längsposition, bevorzugt im Abstand zwischen 10% und 25% der zweiten Länge zur dritten Längsposition begrenzt ist, frei von einem sekundären Verbindungsleiter ist, der zwei sekundäre Leiterstrukturen miteinander und/oder eine primäre Leiterstruktur mit einer sekundären Leiterstruktur verbindet. Der erste Abschnitt und der zweite Abschnitt überschneiden sich zumindest teilweise in Längsrichtung und in Umfangsrichtung. Diese Ausführungsform sieht einen Aufbau der Sekundärspule analog zur Primärspule vor. Dies ermöglicht eine effiziente Schirmung der Primärspule, welche einen ersten Abschnitt frei von einem Verbindungsleiter vorsieht. Die Vorteile einer derartigen Primärspule sind auf diese Ausführungsform übertragbar.

Eine Ausführungsform der Gradientenspuleneinheit sieht vor, dass die sekundären Leiterstrukturen, insbesondere die sekundären Leiterstrukturen, die innerhalb eines sich mit dem zweiten Abschnitt überlappenden Quadranten angeordnet sind, innerhalb des zweiten Abschnittes jeweils die höchste Dichte elektrischer Leiter aufweisen. Die entsprechenden sekundären Leiterstrukturen sind demnach derart ausgestaltet, dass die maximale Dichte des elektrischen Leiters der entsprechenden sekundären Leiterstruktur innerhalb zumindest eines Teilbereiches des zweiten Abschnittes vorliegt. Der Teilbereich umfasst typischerweise zumindest 10%, bevorzugt zumindest 15%, besonders bevorzugt zumindest 20% des zweiten Abschnittes. Insbesondere ist eine innerhalb eines dem ersten Längsende angrenzenden Quadranten angeordnete sekundäre Leiterstruktur derart ausgebildet, dass im zweiten Abschnitt die höchste Stromdichte der Sekundärspule erzeugbar ist.

Gemäß dieser Ausführungsform sehen die in Längsrichtung dem ersten Längsende zugewandten sekundären Leiterstrukturen im ersten Abschnitt einen besonders geringen Abstand zwischen benachbarten Windungen des elektrischen Leiters der sekundären Leiterstrukturen vor. Dies ermöglicht eine besonders hohe Stromdichte am ersten Längsende gemittelt in Längsrichtung über den zweiten Abschnitt an zumindest einer Position in Umfangsrichtung. Die Dichte eines elektrischen Leiters kann durch die Anzahl der elektrischen Leiter pro Querschnittsfläche der Sekundärspule senkrecht zum elektrischen Leiter und/oder die Summe der Fläche der Leiterquerschnitte pro Querschnittsfläche der Sekundärspule senkrecht zum elektrischen Leiter bestimmt sein. Dies ermöglicht innerhalb des zweiten Abschnittes eine besonders hohe Stromdichte, was insbesondere dazu führt, dass ein durch die Primärspule erzeugter Magnetfeldgradient besonders gut abgeschirmt werden kann. Zudem kann die Gradientenspuleneinheit in Längsrichtung im Vergleich zu herkömmlichen Gradientenspuleneinheiten besonders kurz ausgestaltet sein.

Eine Ausführungsform der Gradientenspuleneinheit umfasst einen sekundären Verbindungsleiter, verbindend zwei sekundäre Leiterstrukturen miteinander und/oder eine primäre Leiterstruktur mit einer sekundären Leiterstruktur an eine dem zumindest einen sekundären Fixpunkt nächste Windung der sekundären Leiterstruktur anschließt. Der sekundäre Verbindungsleiter verbindet gemäß dieser Ausführungsform ein Auge einer sekundären Leiterstruktur mit einer weiteren sekundären Leiterstruktur oder primären Leiterstruktur. Dies ermöglicht insbesondere, den zweiten Abschnitt frei von einem Verbindungsleiter, insbesondere einem sekundären Verbindungsleiter, zu gestalten, da der Verbindungsleiter vom sekundären Fixpunkt zum zweiten Längsende führen kann.

Des Weiteren geht die Erfindung aus von einem Magnetresonanzgerät umfassend eine Detektoreinheit mit einem Hauptmagneten, einer Hochfrequenzantenneneinheit und einer erfindungsgemäßen Gradientenspuleneinheit, wobei die Gradientenspuleneinheit die Hochfrequenzantenneneinheit koaxial und/oder konzentrisch umgibt. Das Magnetresonanzgerät umfasst zudem eine Steuerungseinheit ausgebildet zur Ansteuerung der Detektoreinheit. Die räumliche Ausdehnung der Hochfrequenzantenneneinheit in Längsrichtung ist kürzer als die zweite Länge. Die Detektoreinheit umfasst demnach den Hauptmagneten, die erfindungsgemäße Gradientenspuleneinheit und die Hochfrequenzantenneneinheit. Die Sekundärspule weist eine längere räumliche Ausdehnung auf als die Hochfrequenzantenneneinheit. Die Hochfrequenzantenneneinheit ist typischerweise innerhalb der Gradientenspuleneinheit angeordnet. Die Länge der Hochfrequenzantenneneinheit in Längsrichtung kann auch kürzer sein als die erste Länge.

Die Länge der Hochfrequenzantenneneinheit in Längsrichtung ist typischerweise begrenzt durch eine dem ersten Längsende zugewandte siebte Längsposition und eine achte Längsposition. Die siebte Längsposition kann einen geringeren Abstand zu einem Isozentrum der Gradientenspuleneinheit aufweisen als die erste Längsposition und/oder die dritte Längsposition. Die achte Längsposition kann einen geringeren Abstand zu einem Isozentrum der Gradientenspuleneinheit aufweisen als die zweite Längsposition und/oder die vierte Längsposition. Dies verhindert eine räumliche Einschränkung der Öffnung der erfindungsgemäßen Gradientenspuleneinheit am ersten Längsende durch die Hochfrequenzantenneneinheit und ermöglicht demnach guten Zugang zum Untersuchungsbereich. Ausführungsformen des erfindungsgemäßen Magnetresonanzgerätes sind analog zu den

Ausführungsformen der erfindungsgemäßen Gradientenspuleneinheit ausgebildet. Die Vorteile des erfindungsgemäßen Magnetresonanzgeräts entsprechen im Wesentlichen den Vorteilen der erfindungsgemäßen Gradientenspuleneinheeit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt, falls dies im Schutzumfang der Erfindung liegt, welcher durch die Ansprüche definiert ist.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: ein erfindungsgemäßes Magnetresonanzgerät in einer schematischen Darstellung,
- Fig. 2: eine Ausführungsform einer erfindungsgemäßen Gradientenspuleneinheit in einer ersten Ansicht in schematischer Darstellung,
- Fig. 3: eine Ausführungsform einer erfindungsgemäßen Gradientenspuleneinheit in einer zweiten Ansicht,
- Fig. 4: eine schematische Darstellung eines Zylinders zur Erläuterung von Parametern.

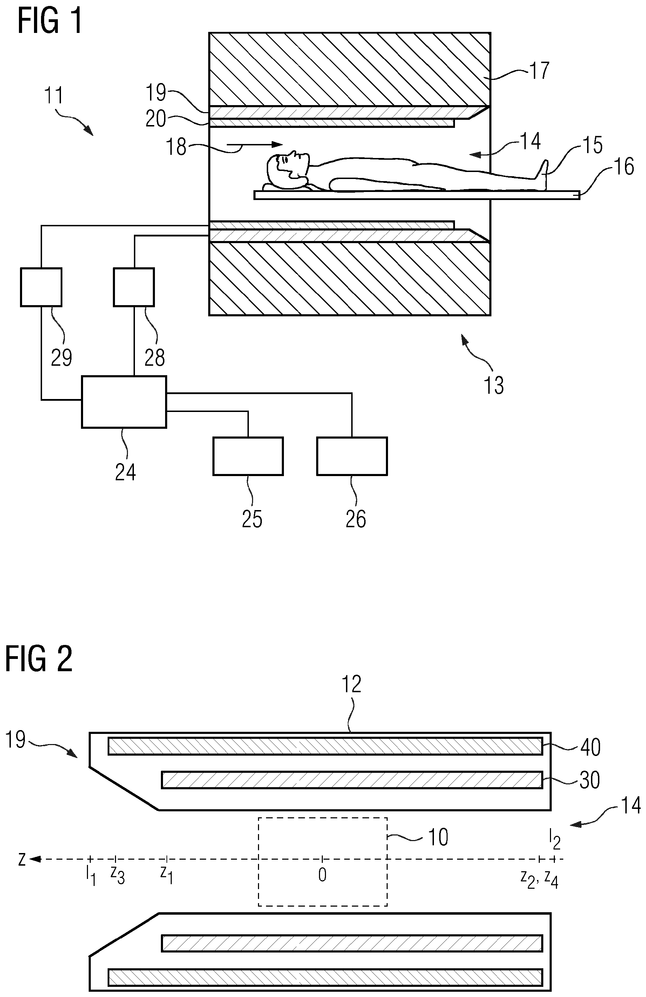

Figur 1 zeigt ein erfindungsgemäßes Magnetresonanzgerät 11. Das Magnetresonanzgerät 11 umfasst eine Detektoreinheit 13 mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Detektoreinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist. Die Detektoreinheit 13 weist weiterhin eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Des Weiteren weist die Detektoreinheit 13 eine erfindungsgemäße Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Die Gradientenspuleneinheit 19 umfasst dabei eine hohlzylindrische Sekundärspule 40 koaxial umgebend eine Primärspule 30, wobei die Sekundärspule 40 eine zweite Länge parallel zum Hauptmagnetfeld 18 aufweist, welche zweite Länge länger ist als erste Länge der Primärspule 30 parallel zum Hauptmagnetfeld 18. Das Hauptmagnetfeld 18 ist vorzugsweise in Längsrichtung ausgerichtet. Die Hochfrequenzantenneneinheit 20 weist eine Länge in Längsrichtung auf, welche kürzer ist als die zweite Länge.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Das Magnetresonanzgerät 11 weist eine Anzeigeeinheit 25 auf. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen. Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

Figur 2 zeigt eine Ausführungsform einer erfindungsgemäßen Gradientenspuleneinheit 19 in einer ersten Ansicht in schematischer Darstellung. Die Gradientenspuleneinheit 19 umfasst eine hohlzylindrische Primärspule 30 und eine hohlzylindrische Sekundärspule 40, welche die Primärspule 30 und den Patientenaufnahmebereich 14 koaxial umgibt. Dabei weist die Sekundärspule 40 typischerweise einen größeren Radius, insbesondere einen größeren Abstand von der z-Achse, auf, als die Primärspule 30. Die Gradientenspuleneinheit 19 ist in Längsrichtung z durch ein erstes Längsende l1 und ein dem ersten Längsende l1 in Längsrichtung z gegenüberliegendes zweites Längsende l2 begrenzt. Das erste Längsende l1 der Gradientenspuleneinheit 19 ist dabei zur Aufnahme eines Untersuchungsobjektes, insbesondere eines Patienten 15, ausgebildet. Die Primärspule 30 weist eine erste Länge in Längsrichtung z auf, welche durch eine dem ersten Längsende l1 zugewandte erste Längsposition z1 und eine dem in Längsrichtung z abgewandte zweite Längsposition z2 begrenzt ist. Die Sekundärspule 40 weist eine zweite Länge begrenzt durch eine dem ersten Längsende l1 zugewandte dritte Längsposition z3 und eine vierte Längsposition z4. Die erste Länge ist kürzer als die zweite Länge und die erste Längsposition z1 weist einen größeren Abstand zum ersten Längsende l1 auf als die dritte Längsposition z3 zum ersten Längsende l1. Die Gradientenspuleneinheit 19 umfasst zudem eine Verschalung 12, welche die Gradientenspuleneinheit 19 zumindest teilweise umschließt und am ersten Längsende l1 trichterförmig ausgestaltet ist. Insbesondere weist die Verschalung 12 ausgehend von der ersten Längsposition z1 zum ersten Längsende l1 senkrecht zur Längsrichtung z eine Verjüngung auf. Das Isozentrum 0 der Gradientenspuleneinheit 19 ist typischerweise der räumliche Mittelpunkt des Außenzylinders und/oder des Innenzylinders und/oder des Untersuchungsbereiches 10. Der Untersuchungsbereich 10 ist ein Teilbereich des Patientenaufnahmebereiches 14.

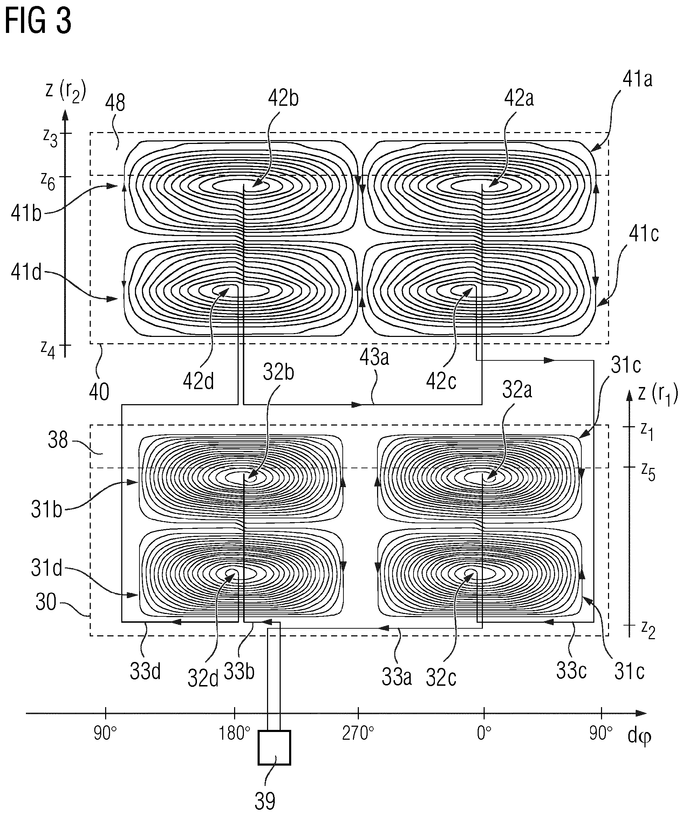

Figur 3 zeigt eine Ausführungsform einer erfindungsgemäßen Gradientenspuleneinheit 19 in einer zweiten Ansicht. Hierbei werden die Primärspule 30 und die Sekundärspule 40 jeweils in abgerollter Form dargestellt. Die Koordinaten der Umfangrichtung dφ gelten für die Primärspule 30 und die Sekundärspule 40. Für die Primärspule 30 und die Sekundärspule 40 sind jeweils separate Achsen in Längsrichtung z angegeben, die sich jedoch zumindest teilweise überlappen. Wie beispielsweise in Figur 2 dargestellt, kann die zweite Längsposition z2 der vierten Längsposition z4 entsprechen. Die Primärspule 30 und die Sekundärspule 40 unterscheiden sich in ihrem radialen Abstand r zur Längsrichtung z. Die Primärspule 30 weist einen ersten Radius r1 zur Längsrichtung z und die Sekundärspule 40 weist einen zweiten Radius r2 zur Längsrichtung z auf, wobei der zweite Radius r2 größer ist als der erste Radius r1.

Die in Figur 3 dargestellte Primärspule 30 ist vorzugsweise zur Erzeugung eines Magnetfeldgradienten in x-Richtung ausgebildet. Die Gradientenspuleneinheit 19 ist in vier Quadranten unterteilbar, welche sich paarweise durch ihre Position in Längsrichtung z oder durch ihre Position in Umfangsrichtung dφ unterscheiden. Ein Quadrant ist beispielsweise durch z = [0; l1] und dφ = [90°; 270°] und ein dem gegenüberliegender Quadrant durch z = [l2; 0] und dφ = [270°; 90°] definiert. Die Primärspule 30 umfasst vier spiralförmige primäre Leiterstrukturen 31a, 31b, 31c, 31d, welche jeweils innerhalb eines Quadranten angeordnet sind. Eine der vier spiralförmigen primären Leiterstrukturen 31a, 31b, 31c, 31d umgibt dabei jeweils zumindest teilweise spiralförmig einen primären Fixpunkt 32a, 32b, 32c, 32d, wobei jeweils einer der vier primären Fixpunkte 32a, 32b, 32c, 32d in jeweils einem Quadranten angeordnet ist. Die Sekundärspule 40 umfasst vier spiralförmige sekundäre Leiterstrukturen 41a, 41b, 41c, 41d, welche jeweils innerhalb eines Quadranten angeordnet sind. Eine der vier spiralförmigen sekundären Leiterstrukturen 41a, 41b, 41c, 41d umgibt dabei jeweils zumindest teilweise spiralförmig einen sekundären Fixpunkt 42a, 42b, 42c, 42d, wobei jeweils einer der vier sekundären Fixpunkte 42a, 42b, 42c, 42d in jeweils einem Quadranten angeordnet ist.

Ein erster Abschnitt 38 der Primärspule 30 ist in Längsrichtung z durch die erste Längsposition z1 und durch eine weitere primäre Längsposition z5 begrenzt, wobei der Abstand der weiteren primären Längsposition z5 zur ersten Längsposition z1 zwischen 10% und 25% der ersten Länge beträgt. Der erste Abschnitt 38 ist frei von einem Verbindungsleiter 33, 43, der zwei primäre Leiterstrukturen 31a, 31b, 31c, 31d miteinander und/oder eine primäre Leiterstruktur 31a, 31b, 31c, 31d mit einer sekundären Leiterstruktur 41a, 41b, 41c, 41d verbindet. Verbindungsleiter 33, 43 sind in Figur 3 schematisch durch gerade Linien dargestellt.

Zudem sind die innerhalb der dem ersten Längsende angrenzenden Quadranten angeordneten primären Leiterstrukturen 31a, 31b derart ausgebildet, dass im ersten Abschnitt 38 die höchste Stromdichte der Primärspule 30 erzeugbar ist und/oder die primären Leiterstrukturen 31a, 31b innerhalb des ersten Abschnittes 38 die höchste Dichte elektrischer Leiter aufweisen. Die Primärspule 30 und insbesondere die von der Primärspule 30 umfassten primären Leiterstrukturen 31a, 31b, 31c, 31d sind demnach derart ausgestaltet, dass innerhalb des ersten Abschnittes 38, insbesondere innerhalb eines Teilbereiches des ersten Abschnittes 38, die höchste Stromdichte der Primärspule 30 erzeugbar ist und/oder die höchste Dichte an elektrischen Leitern der Primärspule 30 vorliegt.

Die Gradientenspuleneinheit 19 umfasst primäre Verbindungsleiter 33a, 33b, 33c, 33d, welche jeweils zwei primäre Leiterstrukturen 31a, 31b, 31c, 31d miteinander und/oder eine primäre Leiterstruktur 31a, 31b, 31c, 31d mit einer sekundären Leiterstruktur 41a, 41b, 41c, 41d verbinden. Ein primärer Verbindungsleiter 33a, 33b, 33c, 33d schließt dabei an eine dem entsprechenden primären Fixpunkt 32a, 32b, 32c, 32d nächste Windung der primären Leiterstruktur 31a, 31b, 31c, 31d an.

Ein zweiter Abschnitt 48 der Sekundärspule 40 ist in Längsrichtung z durch die dritte Längsposition z3 und durch eine weitere sekundäre Längsposition z6 begrenzt, wobei der Abstand der weiteren sekundären Längsposition z6 zur dritten Längsposition z3 höchstens 25%, bevorzugt zwischen 10% und 25% der zweiten Länge beträgt. Der zweite Abschnitt 48 ist frei von einem Verbindungsleiter 33, 43, und insbesondere frei von einem sekundären Verbindungsleiter 43a, der zwei sekundäre Leiterstrukturen 41a, 41b, 41c, 41d miteinander verbindet. Ein Verbindungsleiter 33, 43 kann als primärer Verbindungsleiter 33a, 33b, 33c, 33d und/oder sekundärer Verbindungsleiter 43a ausgebildet sein.

Zudem sind die innerhalb der dem ersten Längsende l1 angrenzenden Quadranten angeordneten sekundären Leiterstrukturen 41a, 41b derart ausgebildet, dass im zweiten Abschnitt 48 die höchste Stromdichte der Sekundärspule 40 erzeugbar ist und/oder die sekundären Leiterstrukturen 41a, 41b innerhalb des zweiten Abschnittes 48 die höchste Dichte elektrischer Leiter aufweisen. Die Sekundärspule 40 und insbesondere die von der Sekundärspule 40 umfassten sekundären Leiterstrukturen 41a, 41b, 41c, 41d sind demnach derart ausgestaltet, dass innerhalb des zweiten Abschnittes 48, insbesondere innerhalb eines Teilbereiches des zweiten Abschnittes 48, die höchste Stromdichte der Sekundärspule 40 erzeugbar ist und/oder die höchste Dichte an elektrischen Leitern der Sekundärspule 40 vorliegt.

Die Gradientenspuleneinheit 19 und insbesondere die Sekundärspule 40 umfassen einen sekundären Verbindungsleiter 43a, der zwei sekundäre Leiterstrukturen 41a, 41b miteinander verbindet und an jeweils eine den sekundären Fixpunkten 42a, 42b nächste Windung der sekundären Leiterstrukturen 41a, 41b anschließt. Weitere sekundäre Leiterstrukturen 41c, 41d können je durch einen primäre Verbindungsleiter 33c, 33d mit je einer primären Leiterstruktur 31c, 31d seriell verbunden sein. Vorzugsweise sind alle primären Leiterstrukturen 31a, 31b, 31c, 31d und sekundären Leiterstrukturen 41a, 41b, 41c, 41d in Serie geschalten, wobei eine elektrische Spannung durch eine Gradientenverstärkereinheit 39 erzeugt wird. Die Gradientenverstärkereinheit 39 ist vorzugsweise als Teil der Gradientensteuereinheit 28 ausgebildet.

Die Gradientenspuleneinheit 19 umfasst vorzugsweise die in Figur 3 dargestellten primären Leiterstrukturen 31a, 31b, 31c, 31d und sekundären Leiterstrukturen 41a, 41b, 41c, 41d ein weiteres Mal, jedoch in Umfangsrichtung dφ um 90° gedreht, welche zur Erzeugung eines Magnetfeldgradienten in y-Richtung ausgebildet sind, insbesondere durch Ansteuerung durch eine weitere Gradientenverstärkereinheit.

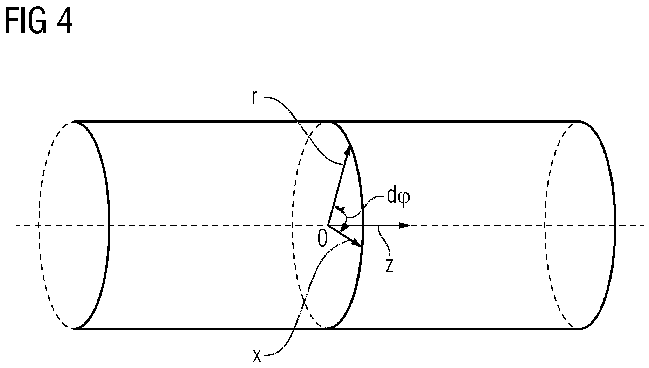

Figur 4 zeigt eine schematische Darstellung eines Zylinders zur Erläuterung von Parametern. Die Zylinderachse entspricht der Längsrichtung z, insbesondere der Längsrichtung z der Gradientenspuleneinheit 19. Die Umfangrichtung kann durch dφ charakterisiert werden. Die Richtung senkrecht zur Umfangrichtung dφ wird als radiale Richtung r bezeichnet. Die mit x bezeichnete Richtung ist typischerweise senkrecht zur Längsrichtung z und horizontal ausgerichtet.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche gegeben ist.

## Patentansprüche

1. Gradientenspuleneinheit (19) für interventionelle Magnetresonanzbildgebung umgebend einen zylindrischen Patientenaufnahmebereich (14) und umfassend eine hohlzylindrische Primärspule (30) und eine hohlzylindrische Sekundärspule, welche die Primärspule (30) und den Patientenaufnahmebereich (14) koaxial umgibt,
wobei die Gradientenspuleneinheit (19) ein erstes Längsende (l1) in eine Längsrichtung aufweist, welches erste Längsende (l1) zur Aufnahme eines Untersuchungsobjektes (15) ausgebildet ist, und die Gradientenspuleneinheit (19) ein dem ersten Längsende (l1) in Längsrichtung gegenüberliegendes zweites Längsende (l2) aufweist,
wobei die Primärspule (30) eine erste Länge in Längsrichtung aufweist, welche erste Länge durch eine dem ersten Längsende (l1) zugewandte erste Längsposition (z1) und eine dem zweiten Längsende (l2) zugewandte zweite Längsposition (z2) begrenzt ist,
wobei die Sekundärspule (40) eine zweite Länge in Längsrichtung aufweist, welche zweite Länge durch eine dem ersten Längsende (l1) zugewandte dritte Längsposition (z3) und eine dem zweiten Längsende (l2) zugewandte vierte Längsposition (z4) begrenzt ist,
wobei die erste Längsposition (z1) einen größeren Abstand zum ersten Längsende (l1) aufweist als die dritte Längsposition (z3),
die Gradientenspuleneinheit (19) in vier Quadranten unterteilbar ist,
die Primärspule (30) vier spiralförmige primäre Leiterstrukturen (31a, 31b, 31c, 31d) umfasst, welche jeweils innerhalb eines Quadranten umgebend jeweils einen primären Fixpunkt (32a, 32b, 32c, 32d) angeordnet sind,
die Sekundärspule (40) vier spiralförmige sekundäre Leiterstrukturen (41a, 41b, 41c, 41d) umfasst, welche jeweils innerhalb eines Quadranten umgebend jeweils einen sekundären Fixpunkt (42a, 42b, 42c, 42d) angeordnet sind,
und **dadurch gekennzeichnet ist, dass** ein erster Abschnitt (38) der Primärspule (30), welcher in Längsrichtung durch die erste Längsposition (z1) und durch eine weitere primäre Längsposition im Abstand zwischen 10% und 25% der ersten Länge zur ersten Längsposition (z1) begrenzt ist, frei von einem Verbindungsleiter ist, welcher Verbindungsleiter zwei primäre Leiterstrukturen (31a, 31b, 31c, 31d) miteinander und/oder eine primäre Leiterstruktur (31a, 31b, 31c, 31d) mit einer sekundären Leiterstruktur (41a, 41b, 41c, 41d) verbindet.

2. Gradientenspuleneinheit (19) nach Anspruch 1,
umfassend eine Verschalung (12), welche die Gradientenspuleneinheit (19) zumindest teilweise umschließt und am ersten Längsende (l1) trichterförmig ausgestaltet ist.

3. Gradientenspuleneinheit (19) nach einem der vorangehenden Ansprüche,
wobei sich die erste Längsposition (z1) und die dritte Längsposition (z3) um zumindest 3 cm unterscheiden.

4. Gradientenspuleneinheit (19) nach einem der vorangehenden Ansprüche,
wobei sich die zweite Längsposition (z2) und die vierte Längsposition (z4) um höchstens 4 cm unterscheiden.

5. Gradientenspuleneinheit (19) nach einem der vorangehenden Ansprüche,
wobei die Gradientenspuleneinheit (19) einen Innendurchmesser von zumindest 840 mm und eine räumliche Ausdehnung in Längsrichtung von höchstens 1350 mm aufweist.

6. Gradientenspuleneinheit (19) nach einem der vorangehenden Ansprüche,
wobei die primären Leiterstrukturen (31a, 31b, 31c, 31d), welche innerhalb eines sich mit dem ersten Abschnitt (38) überlappenden Quadranten angeordnet sind, innerhalb des ersten Abschnittes (38) jeweils die höchste Dichte elektrischer Leiter aufweisen.

7. Gradientenspuleneinheit (19) nach einem der vorangehenden Ansprüche,
umfassend einen primären Verbindungsleiter (33a, 33b, 33c, 33d), verbindend zwei primäre Leiterstrukturen (31a, 31b, 31c, 31d) miteinander und/oder eine primäre Leiterstruktur (31a, 31b, 31c, 31d) mit einer sekundären Leiterstruktur (33a, 33b, 33c, 33d), und welcher an eine dem zumindest einen primären Fixpunkt (32a, 32b, 32c, 32d) nächste Windung der primären Leiterstruktur (31a, 31b, 31c, 31d) anschließt.

8. Gradientenspuleneinheit (19) nach einem der vorangehenden Ansprüche,
wobei ein zweiter Abschnitt (48) der Sekundärspule (40), welcher in Längsrichtung durch die dritte Längsposition (z3) und durch eine weitere sekundäre Längsposition im Abstand von höchstens 25% der zweiten Länge zur dritten Längsposition (z3) begrenzt ist, frei von einem sekundären Verbindungsleiter (43a) ist, der zwei sekundäre Leiterstrukturen (41a, 41b, 41c, 41d) miteinander und/oder eine primäre Leiterstruktur (31a, 31b, 31c, 31d) mit einer sekundären Leiterstruktur (41a, 41b, 41c, 41d) verbindet.

9. Gradientenspuleneinheit (19) nach Anspruch 8,
wobei die sekundären Leiterstrukturen (41a, 41b, 41c, 41d), welche innerhalb eines sich mit dem zweiten Abschnitt (48) überlappenden Quadranten angeordnet sind, innerhalb des zweiten Abschnittes (48) jeweils die höchste Dichte elektrischer Leiter aufweisen.

10. Gradientenspuleneinheit (19) nach einem der vorangehenden Ansprüche,
umfassend einen sekundären Verbindungsleiter (43a), verbindend zwei sekundäre Leiterstrukturen (41a, 41b, 41c, 41d) miteinander und/oder eine primäre Leiterstruktur (31a, 31b, 31c, 31d) mit einer sekundären Leiterstruktur (41a, 41b, 41c, 41d), und welcher an eine dem zumindest einen sekundären Fixpunkt (42a, 42b, 42c, 42d) nächste Windung der sekundären Leiterstruktur (41a, 41b, 41c, 41d) anschließt.

11. Magnetresonanzgerät (11) umfassend eine Detektoreinheit (13) mit einem Hauptmagneten (17), einer Hochfrequenzantenneneinheit (20) und einer Gradientenspuleneinheit (19) nach einem der vorangehenden Ansprüche, wobei die Gradientenspuleneinheit (19) die Hochfrequenzantenneneinheit (20) koaxial umgibt, und eine Steuerungseinheit (24) ausgebildet zur Ansteuerung der Detektoreinheit (13), wobei eine räumliche Ausdehnung der Hochfrequenzantenneneinheit (20) in Längsrichtung kürzer ist als die zweite Länge.

## Claims

1. Gradient coil unit (19) for interventional magnetic resonance imaging surrounding a cylindrical patient receiving region (14) and comprising a hollow cylindrical primary coil (30) and a hollow cylindrical secondary coil that surrounds the primary coil (30) and the patient receiving region (14) in a coaxial manner,
wherein the gradient coil unit (19) has a first longitudinal end (11) in a longitudinal direction, which first longitudinal end (11) is designed so as to receive an examination object (15) and the gradient coil unit (19) has a second longitudinal end (12) that lies opposite the first longitudinal end (11) in the longitudinal direction,
wherein the primary coil (30) has a first length in the longitudinal direction, which first length is delimited by a first longitudinal position (z1) that is facing the first longitudinal end (11), and a second longitudinal position (z2) that is facing the second longitudinal end (12),
wherein the secondary coil (40) has a second length in the longitudinal direction, which second length is delimited by a third longitudinal position (z3) that is facing the first longitudinal end (11), and a fourth longitudinal position (z4) that is facing the second longitudinal end (12),
wherein the first longitudinal position (z1) has a greater spacing with respect to the first longitudinal end (11) than the third longitudinal position (z3),
the gradient coil unit (19) can be divided into four quadrants,
the primary coil (30) comprises four helical primary conductor structures (31a, 31c, 31c, 31d) that are arranged in each case within a quadrant surrounding a respective primary fix point (32a, 32b, 32c, 32d),
the secondary coil (40) comprises four helical secondary conductor structures (41a, 41b, 41c, 41d) that are arranged in each case within a quadrant surrounding a respective secondary fix point (42a, 42b, 42c, 42d),
and **characterised in that** a first section (38) of the primary coil (30), which section is delimited in the longitudinal direction by the first longitudinal position (z1) and by a further primary longitudinal position at a spacing of between 10% and 25% of the first length with respect to the first longitudinal position (z1), is not provided with a connecting conductor, which connecting conductor connects two primary conductor structures (31a, 31b, 31c, 31d) to one another and/or a primary conductor structure (31a, 31b, 31c, 31d) to a secondary conductor structure (41a, 41b, 41c, 41d).

2. Gradient coil unit (19) according to claim 1,
comprising a casing (12) that at least in part encompasses the gradient coil unit (19) and is designed as funnel-shaped on the first longitudinal end (11).

3. Gradient coil unit (19) according to one of the preceding claims,
wherein the first longitudinal position (z1) and the third longitudinal position (z3) differ by at least 3 cm.

4. Gradient coil unit (19) according to one of the preceding claims,
wherein the second longitudinal position (z2) and the fourth longitudinal position (z4) differ by at most 4 cm.

5. Gradient coil unit (19) according to one of the preceding claims,
wherein the gradient coil unit (19) has an inner diameter of at least 840 mm and a spatial extent in the longitudinal direction of at most 1350 mm.

6. The gradient coil unit (19) according to one of the preceding claims,
wherein the primary conductor structures (31a, 31b, 31c, 31d), which are arranged within a quadrant that overlaps with the first section (38), have in each case the highest density of electrical conductors within the first section (38).

7. Gradient coil unit (19) according to one of the preceding claims,
comprising a primary connecting conductor (33a, 33b, 33c, 33d), which connects two primary conductor structures (31a, 31b, 31c, 31d) to one another and/or a primary conductor structure (31a, 31b, 31c, 31d) to a secondary conductor structure (33a, 33b, 33c, 33d) and which connects to a winding of the primary conductor structure (31a, 31b, 31c, 31d), which is closest to the at least one primary fix point (32a, 32b, 32c, 32d).

8. Gradient coil unit according to one of the preceding claims,
wherein a second section (48) of the secondary coil (40) that is delimited in the longitudinal direction by the third longitudinal position (z3) and by a further secondary longitudinal position at a spacing of at most 25% of the second length with respect to the third longitudinal position (z3), and is not provided with a secondary connecting conductor (43a) that connects two secondary conductor structures (41a, 41b, 41c, 41d) to one another and/or a primary conductor structure (31a, 31b, 31c, 31d) to a secondary conductor structure (41a, 41b, 41c, 41d).

9. Gradient coil unit according to claim 8,
wherein the secondary conductor structures (41a, 41b, 41c, 41d), which are arranged within a quadrant that overlaps with the second section (48), have in each case the highest density of electrical conductors within the second section (48).

10. Gradient coil unit (19) according to one of the preceding claims,
comprising a secondary connecting conductor (43a), which connects two secondary conductor structures (41a, 41b, 41c, 41d) to one another and/or a primary conductor structure (31a, 31b, 31c, 31d) to a secondary conductor structure (41a, 41b, 41c, 41d) and which connects to a winding of the secondary conductor structure (41a, 41b, 41c, 41d), which is closest to the at least one secondary fix point (42a, 42b, 42c, 42d).

11. Magnetic resonance device (11) comprising a detector unit (13) having a main magnet (17), a radio frequency antenna unit (20) and a gradient coil unit (19) according to one of the preceding claims, wherein the gradient coil unit (19) surrounds the radio frequency antenna unit (20) in a coaxial manner, and a control unit that (24) is designed so as to control the detector unit (13), wherein a spatial extent of the radio frequency antenna unit (20) in the longitudinal direction is shorter than the second length.

## Revendications

1. Unité (19) à bobines de gradient pour imagerie par résonnance magnétique interventionnelle comprenant une partie (14) cylindrique de réception de patient et comprenant une bobine (30) primaire cylindrique creuse et une bobine secondaire cylindrique creuse, qui entoure coaxialement la bobine (30) primaire et la partie (14) de réception du patient,
dans laquelle l'unité (19) à bobines de gradient a une première extrémité (l1) longitudinale dans une direction longitudinale, laquelle première extrémité (11) longitudinale est constituée pour la réception d'un objet (15) à examiner, et l'unité (19) à bobines de gradient a une deuxième extrémité (12) longitudinale opposée suivant la direction longitudinale à la première extrémité (11) longitudinale,
dans laquelle la bobine (30) primaire a une première longueur dans la direction longitudinale, laquelle première longueur est délimitée par une première position (z1) en longueur, tournée vers la première extrémité (l1) longitudinale, et par une deuxième position (z2) en longueur, tournée vers la deuxième extrémité (12) longitudinale,
dans laquelle la bobine (40) secondaire a une deuxième longueur dans la direction longitudinale, laquelle deuxième longueur est délimitée par une troisième position (z3) en longueur, tournée vers la première extrémité (11) longitudinale, et par une quatrième position (z4) en longueur, tournée vers la deuxième extrémité (12) longitudinale,
dans laquelle la première position (z1) longitudinale est à une distance plus grande de la première extrémité (11) longitudinale que ne l'est la troisième position (z3) longitudinale,
l'unité (19) à bobines de gradient peut être subdivisée en quatre cadrans,
la bobine (30) primaire comprend quatre structures (31a, 31b, 31c, 31d) conductrices primaires en forme de spirale, qui sont disposées respectivement à l'intérieur d'un cadran entourant respectivement un point (32a, 32b, 32c, 32d) fixe primaire,
la bobine (40) secondaire comprend quatre structures (41a, 41b, 41c, 41d) conductrices secondaires en forme de spirale, qui sont disposées respectivement à l'intérieur d'un cadran entourant respectivement un point (42a, 42b, 42c, 42d) fixe secondaire,
et **caractérisée en ce qu'**un premier tronçon (38) de la bobine (30) primaire, qui est délimité dans la direction longitudinale par la première position (z1) en longueur et par une autre position en longueur primaire à distance, entre 10 % et 25 % de la première longueur, de la première position (z1) longitudinale, est exempt d'un conducteur de liaison, lequel conducteur de liaison connecte deux structures (31a, 31b, 31c, 31d) conductrices primaires entre elles et/ou une structure (31a, 31b, 31c, 31d) conductrice primaire à une structure (41a, 41b, 41c, 41d) conductrice secondaire.

2. Unité (19) à bobines de gradient suivant la revendication 1,
comprenant un coffrage (12), qui entoure au moins en partie l'unité (19) à bobines de gradient et qui est conformé en forme de trémie à la première extrémité (l1) longitudinale.

3. Unité (19) à bobines de gradient suivant l'une des revendications précédentes,
dans laquelle la première position (z1) longitudinale et la troisième position (z3) longitudinale se distinguent d'au moins 3 cm.

4. Unité (19) à bobines de gradient suivant l'une des revendications précédentes,
dans laquelle la deuxième position (z2) longitudinale et la quatrième position (z4) longitudinale se distinguent de 4 cm au plus.

5. Unité (19) à bobines de gradient suivant l'une des revendications précédentes,
dans laquelle l'unité (19) à bobines de gradient a un diamètre intérieur d'au moins 840 mm et une étendue dans l'espace dans la direction longitudinale d'au plus 1350 mm.

6. Unité (19) à bobines de gradient suivant l'une des revendications précédentes,
dans laquelle les structures (31a, 31b, 31c, 31d) conductrices primaires, qui sont disposées à l'intérieur d'un cadran à chevauchement avec le premier tronçon (38), ont, à l'intérieur du premier tronçon (38), respectivement la densité la plus grande de conducteurs électriques.

7. Unité (19) à bobines de gradient suivant l'une des revendications précédentes,
comprenant un conducteur (33a, 33b, 33c, 33d) primaire de connexion, connectant deux structures (31a, 31b, 31c, 31d) conductrices primaires l'une à l'autre et/ou une structure (31a, 31b, 31c, 31d) conductrice primaire à une structure (33a, 33b, 33c, 33d) conductrice secondaire, et qui se raccorde à une spire, la plus proche du au moins un point (32a, 32b, 32c, 32d) fixe primaire, de la structure (31a, 31b, 31c, 31d) conductrice primaire.

8. Unité (19) à bobines de gradient suivant l'une des revendications précédentes,
dans laquelle un deuxième tronçon (48) de la bobine (40) secondaire, qui est délimité dans la direction longitudinale par la troisième position (z3) en longueur et par une position en longueur secondaire supplémentaire, à distance d'au plus 25 % de la deuxième longueur, de la troisième position (z3) en longueur, est exempt d'un conducteur (43a) secondaire de connexion, qui connecte deux structures (41a, 41b, 41c, 41d) conductrices secondaires entre elles et/ou une structure (31a, 31b, 31c, 31d) conductrice primaire à une structure (41a, 41b, 41c, 41d) conductrice secondaire.

9. Unité (19) à bobines de gradient suivant la revendication 8,
dans laquelle les structures (41a, 41b, 41c, 41d) conductrices secondaires, qui sont disposées à l'intérieur d'un cadran à chevauchement avec le deuxième tronçon (48) ont, à l'intérieur du deuxième tronçon (48), respectivement la densité la plus grande de conducteurs électriques.

10. Unité (19) à bobines de gradient suivant l'une des revendications précédentes,
comprenant un conducteur (43a) secondaire de connexion, connectant deux structures (41a, 41b, 41c, 41d) conductrices secondaires entre elles et/ou une structure (31a, 31b, 31c, 31d) conductrice primaire à une structure (41a, 41b, 41c, 41d) conductrice secondaire, et qui se raccorde à une spire, la plus proche du au moins un point (42a, 42b, 42c, 42d) fixe secondaire, de la structure (41a, 41b, 41c, 41d) conductrice secondaire.

11. Appareil (11) de résonnance magnétique comprenant une unité (13) de détecteur ayant un aimant (17) principal, une unité (20) d'antenne à haute fréquence et une unité (19) à bobines de gradient suivant l'une des revendications précédentes, dans lequel l'unité (19) à bobines de gradient entoure coaxialement l'unité (20) d'antenne à haute fréquence, et constitue une unité (24) de commande pour la commande de l'unité (13) de détecteur, dans lequel une étendue dans l'espace de la partie (20) d'antenne à haute fréquence est plus courte dans la direction longitudinale que la deuxième longueur.
